# EUROPEAN PATENT APPLICATION

(11) **EP 2 481 499 A2**
(43) Date of publication of application: **01.08.2012**
(21) Application number: 11185975.7
(22) Date of filing: 20.10.2011
(51) Int. Cl.: B22D 17/20, B22D 17/24, B22D 19/00

(54) **Method and device for manufacturing cover including multiple metal layers**

(30) Priority: 01.02.2011 CN 201110037281
(71) Applicant: Zoltrix Material (Guangzhou) Limited, Panyu, Guangdong (CN); Dongguan Grand Fame Industry, Dongguan City, Guangdong (CN)
(72) Inventor: Liu, Chi Hung Kevin, Dagang, Panyu Guangdong (CN); Ho, Chi Hung, Dagang, Panyu Guangdong (CN)
(74) Representative: Mertens, Hans Victor

(57) **Abstract**

A method and a device for manufacturing a cover including multiple metal layers are provided. The method includes: injecting a second metal in liquid form which is a metal different from a first metal layer onto a semi-finished cover disposed in a mold and formed of the first metal layer, so as to form a second metal layer on the first metal layer; and pressing the second metal layer with a pressure in the mold. Not only does the multi-layer metal cover manufactured according to the method have the strength and elasticity of a composite metal, but also subsequent surface treatment may be performed on the metal cover as required, such as heat treatment, anodizing surface treatment, Galvanic plating, vacuum coating/film treatment, coating treatment, painting treatment, and corrosion resistant treatment, to further improve the adhesiveness between metal layers, the strength and the corrosion resistance, and make the design of the cover more flexible.

## Description

### Field of the Invention

The present invention relates to a method and a device for manufacturing a cover including a metal, and more particularly to a method and a device for manufacturing a cover including multiple metal layers.

### Background of the Invention

With the rapid development in consumer electronics, consumers not only want the products to have good substantial performance, such as processing speed and storage capability in a portable computer or tablet computer and communication transmission in a mobile phone, but also have increasingly higher requirements for their appearance and durability. A metal casing which has pleasing appearance, good strength, and high ductility while being light weight will thus become more and more important to consumer electronic products.

A colorful plastic casing of a conventional electronic product is easily broken by external impact, while a casing of a single metal layer may rust due to environmental factors, or subsequent surface treatment cannot be performed on the casing due to the limitation of material properties. Therefore, multiple metal layers that are rust proof and scratch resistant and have high strength which plastic or single metallic part cannot reach and pleasing appearance are needed to solve the various problems of the single metal layer. However, in the prior art, a casing formed of double metal layers or of a mechanical laminate of materials is prepared by vacuum evaporation or ion sputtering for a consumer electronic apparatus, which entails high manufacturing cost.

### Summary Of the Invention

The present invention aims to eliminate the problems with the prior art, and manufacture a cover including multiple metal layers at low cost and high yield, by preparing materials according to actual material consumption, thus being more environmental friendly and cost efficient than the technology currently available. Meanwhile, different metals of double layers or multiple layers may be designed to completely or partially cover a substrate, so as to meet the requirements for appearance and mechanical performance at the same time, which will save a large amount of work in developing different alloy materials and save global resources.

The method and the device of the present invention achieve good adhesiveness between multiple metal layers and improve the metal compactness and the surface smoothness, and facilitate subsequent metal surface treatment.

An embodiment of the present invention provides a method for manufacturing a cover including multiple metal layers, which includes: injecting a second metal in liquid form which is a metal different from a first metal layer onto a semi-finished cover which is disposed in a mold and formed of the first metal layer, so as to form a second metal layer on the first metal layer; and pressing the second metal layer with a pressure in the mold.

Another embodiment of the present invention provides a device for manufacturing a cover including multiple metal layers, which includes: a mold, used for injecting a second metal in liquid form which is a metal different from a first metal layer onto a cover disposed in the mold and formed of the first metal layer, so as to form a second metal layer on the first metal layer, in which the mold includes a pressing component for applying a pressure to the second metal layer located in the mold.

Yet another embodiment of the present invention provides a method for manufacturing a cover including multiple metal layers, which includes: injecting a first metal in liquid form into a space between a first front mold and a rear mold operating in cooperation with the first front mold, so as to form a first metal layer; and injecting a second metal in liquid form onto the first metal layer in a semi-solid molten state in a second front mold in cooperation with the rear mold, so as to form a second metal layer on the first metal layer.

Yet another embodiment of the present invention provides a device for manufacturing a cover including multiple metal layers, which includes: a first front mold, operating in cooperation with a rear mold and used to inject a first metal in liquid form, so as to form a first metal layer; and a second front mold, operating in cooperation with the rear mold and used to inject a second metal in liquid form onto the first metal layer in a semi-solid molten state, so as to form a second metal layer on the first metal layer.

### Brief Description of the Drawing

FIG. 1 illustrates a method according to a preferred embodiment of the present invention;

FIG. 2-1 illustrates an open state of a device according to a preferred embodiment of the present invention;

FIG. 2-2 illustrates a closed state of a device according to a preferred embodiment of the present invention;

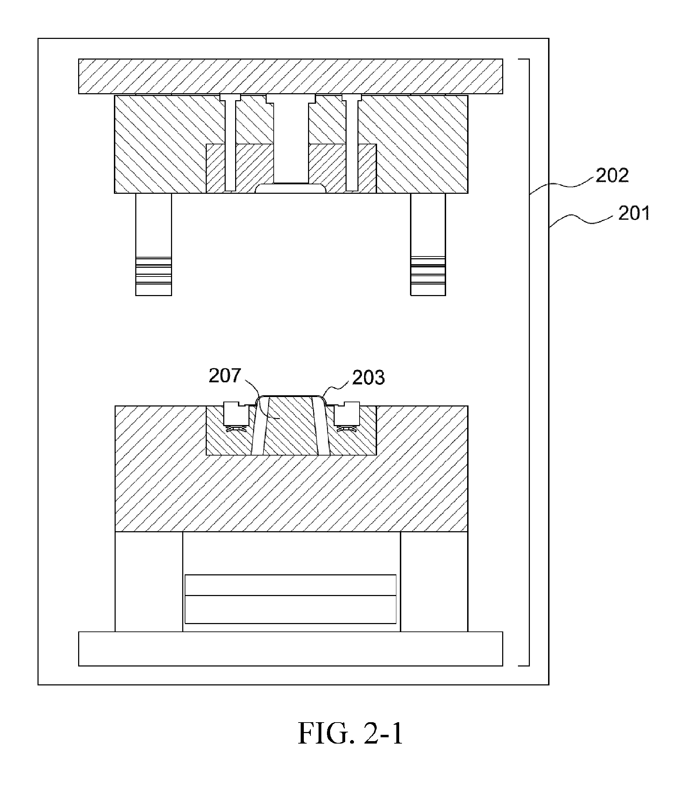

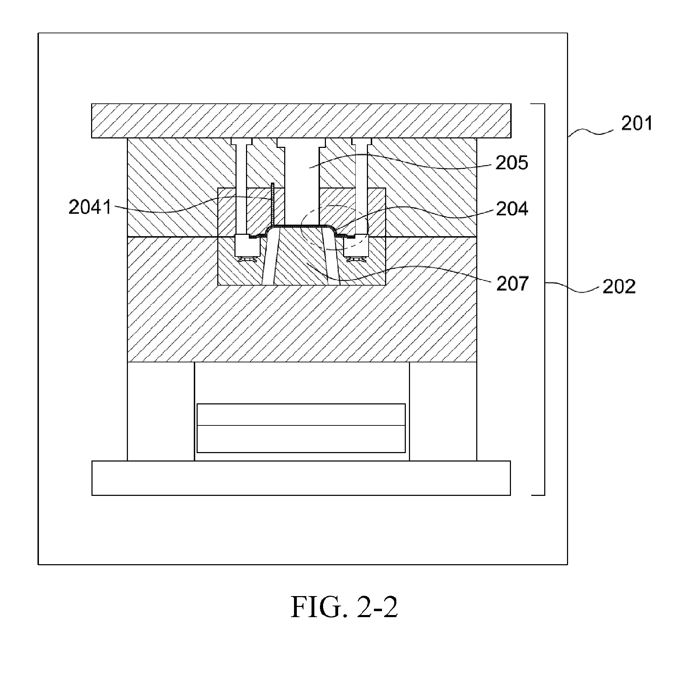

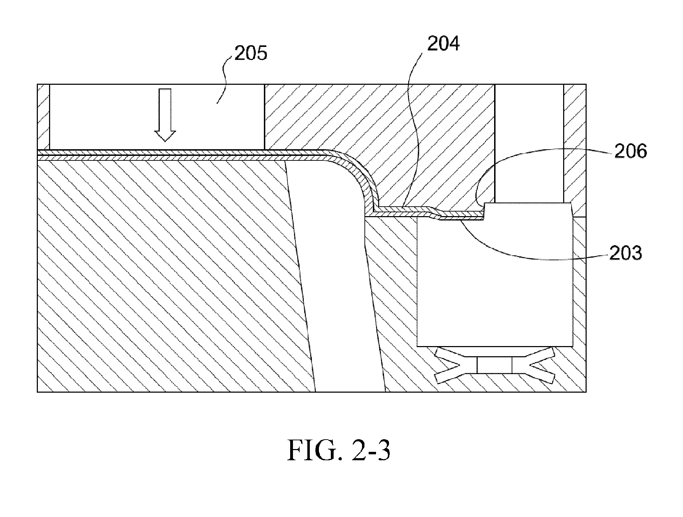

FIG. 2-3 is a partially enlarged view of FIG. 2-2;

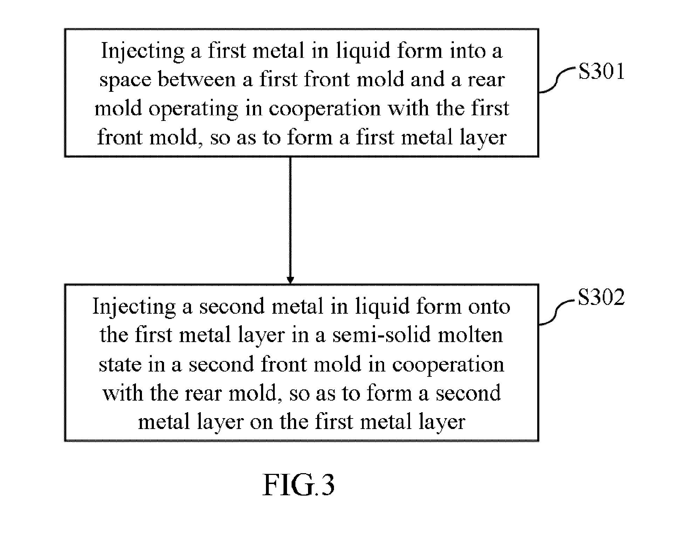

FIG. 3 illustrates a method according to another preferred embodiment of the present invention; and

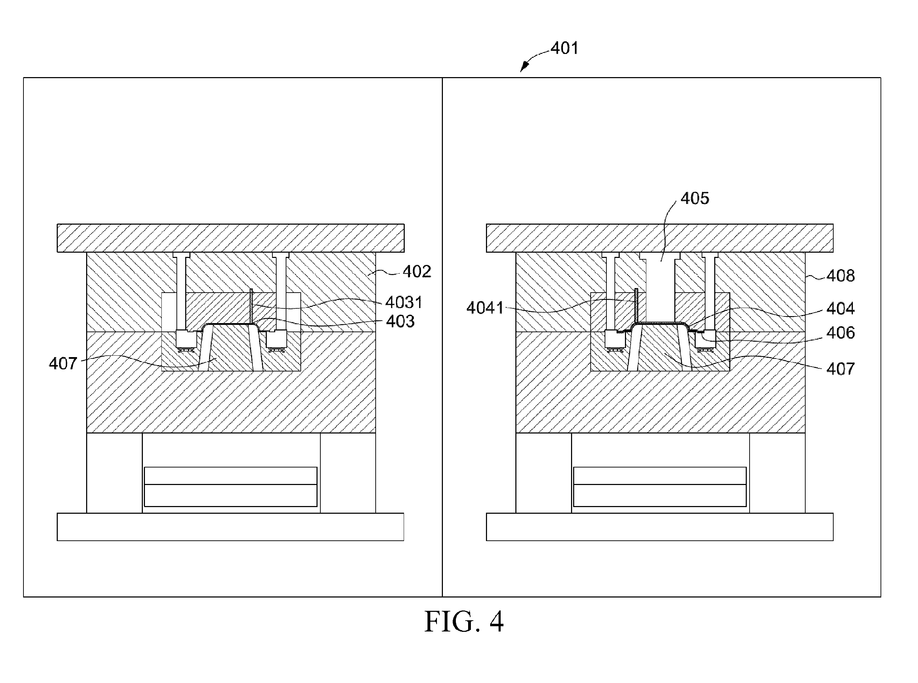

FIG. 4 illustrates a device according to another preferred embodiment of the present invention.

### Detailed Description of the Invention

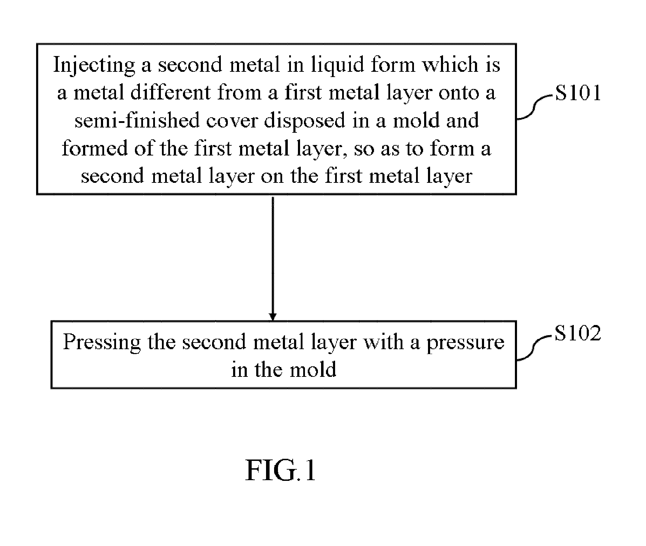

An embodiment of a method according to the present invention is shown in FIG. 1, and the method includes: injecting a second metal in liquid form which is a metal different from a first metal layer onto a semi-finished cover which is disposed in a mold and formed of the first metal layer, so as to form a second metal layer on the first metal layer (S101), and pressing the second metal layer with a pressure in the mold (5102). A third metal in liquid form may be injected onto the second metal to form a three-layer cover by repeating the operation.

The injection operation includes different aspects such as high-pressure injection molding, pouring or flowing. The pressure helps to improve the adhesiveness between the first metal layer and the second metal layer, remove bubbles in the second metal material in a liquid state, and improve the compactness of the second metal layer, so that no pore is left after cooling and curing of the second metal layer, thereby achieving the strength of a composite metal. This may also prevent the formation of a liquid flow mark due to flowing of the metal in liquid form during the injection of the second metal in liquid form. The process of pressing the second metal layer may also enable a surplus of the second metal in liquid form material to overflow. Not only does the multi-layer metal cover manufactured according to the method of the present invention have the strength and elasticity of a composite metal, but also subsequent surface treatment may be performed on the metal cover as required, such as heat treatment, anodizing surface treatment, Galvanic plating, vacuum coating/film treatment, coating treatment, painting treatment and corrosion resistant treatment, to further improve the adhesiveness between metal layers, the strength and the corrosion resistance, and make the design of the cover more flexible.

In a preferred embodiment, the materials of the first metal layer and the second metal layer may be stainless steel, zinc, aluminum, magnesium, chromium, titanium, copper, beryllium, nickel or an alloy thereof, or other metals and alloys. The first metal layer with a small specific weight may first be formed, and then the second metal layer with a large specific weight is formed; or the first metal layer with a large specific weight may first be formed, and then the second metal layer with a small specific weight is formed. For example, if the first metal layer is formed of a zinc alloy, and the second metal layer is formed of an aluminum alloy, the strength of a composite metal may be achieved, and subsequent anodizing surface treatment may be performed on the second metal layer. In another example, the first metal layer is formed of an aluminum alloy or a magnesium alloy, and the second metal layer is formed of stainless steel, so that subsequent treatment such as direct current electroplating or vacuum evaporation may be conveniently performed on a surface of the second metal layer, thereby further forming a subsequent metal or non-metal layer.

Another preferred embodiment of the present invention discloses a device for manufacturing a cover including multiple metal layers. FIG. 2-1 illustrates an open state of a device 201 according to a preferred embodiment of the present invention. The device 201 includes a mold 202, and a semi-finished cover (a first metal layer 203) formed of a first metal is disposed in the mold 202 (that is, on a rear mold 207). FIG. 2-2 illustrates a closed state of the device 201. In the closed state, a second metal in liquid form 2041 which is a different metal from the first metal layer 203 is injected onto the semi-finished cover disposed in the mold 202 and formed of the first metal layer 203, so as to form a second metal layer 204 on the first metal layer 203.

FIG. 2-3 is a partially enlarged view of FIG. 2-2. The mold 202 includes a pressing component 205, for applying a pressure to the second metal layer 204 located in the mold 202.

In a preferred embodiment, a reserved space is provided between the rear mold 207 and the pressing component 205, so that the second metal in liquid form 2041 may be injected into the reserved space. Moreover, the mold 202 may additionally include an overflow port 206, so that a surplus of the second metal in liquid form overflows through the overflow port 206 when the pressing component 205 presses the second metal layer 204.

Yet another preferred embodiment of the present invention relates to a method for manufacturing a cover including multiple metal layers. As shown in FIG. 3, the method of the present invention includes: injecting a first metal in liquid form into a space between a first front mold and a rear mold operating in cooperation with the first front mold, so as to form a first metal layer (S301); and in a second front mold operating in cooperation with the rear mold, injecting a second metal in liquid form onto the first metal layer in a semi-solid molten state, so as to form a second metal layer on the first metal layer (5302). A cover with three layers or more may also be formed in the same manner as required.

The difference from the method in FIG. 1 lies in that, when the first metal layer is in the semi-solid molten state, the second metal layer is formed thereon, which not only improves the adhesiveness between the first metal layer and the second metal layer, but also reduces cost and saves time, thereby improving the yield.

Yet another preferred embodiment of the present invention provides a device for implementing the method shown in FIG. 3. As shown in FIG. 4, a device 401 of this embodiment includes: a first front mold 402, capable of operating in cooperation with a rear mold 407 and used to inject a first metal in liquid form 4031, so as to form a first metal layer 403; and a second front mold 408, operating in cooperation with the rear mold 407 and used to inject a second metal in liquid form 4041 onto the first metal layer 403 in a semi-solid molten state, so as to form a second metal layer 404 on the first metal layer 403.

In yet another preferred embodiment of the present invention, when the second front mold 408 operates in cooperation with the rear mold 407, a reserved space is provided between the rear mold 407 and a pressing component 405, so that the second metal in liquid form may be injected into the reserved space.

Moreover, the pressing component 405 in the second front mold 408 may be used to apply a pressure to the second metal layer 404. Furthermore, the rear mold 407 further includes an overflow port 406, so that a surplus of the second metal in liquid form may overflow through the overflow port 406 when the pressing component 405 applies a pressure to the second metal layer 404.

In yet another preferred embodiment of the present invention, the device 401 further includes a movement component, for relatively moving the rear mold 407 between the first front mold 402 and the second front mold 408. For example, the rear mold 407 may be moved from the first front mold 402 to the second front mold 408 after the first metal in liquid form is injected; or the first front mold 402 is moved away after the first metal in liquid form is injected, and the second front mold 408 is moved to a position operating in cooperation with the rear mold 407, so as to inject the second metal in liquid form. Through this embodiment, the injection of both the first metal in liquid form and the second metal in liquid form is performed in the same device, which may make the procedure simpler.

According to the present invention, a metal cover with three layers or more may also be formed in the same manner as required.

Not only does the multi-layer metal cover manufactured according to the method of the present invention have the strength and elasticity of a composite metal, but also subsequent surface treatment may be performed on the metal cover as required, such as heat treatment, anodizing surface treatment, Galvanic plating, vacuum coating/film treatment, coating treatment, painting treatment, and corrosion resistant treatment, to further improve the adhesiveness between metal layers, the strength and the corrosion resistance, and make the design of the cover more flexible.

Although the technical contents and features of the present invention are described above, various variations and modifications can be made by persons of ordinary skill in the art without departing from the teaching and disclosure of the present invention. Therefore, the scope of the present invention is not limited to the disclosed embodiments, but encompasses other variations and modifications that do not depart from the present invention as defined by the appended claims.

## Claims

1. A method for manufacturing a cover comprising multiple metal layers, comprising:
injecting a second metal in liquid form which is a metal different from a first metal layer , onto a semi-finished cover which is disposed in a mold and formed of the first metal layer, so as to form a second metal layer on the first metal layer; and
pressing the second metal layer with a pressure in the mold.

2. The method according to Claim 1, wherein the materials of the first metal layer and the second metal layer comprise stainless steel, zinc, aluminum, magnesium, chromium, titanium, copper, beryllium, nickel or an alloy thereof.

3. A device for manufacturing a cover comprising multiple metal layers, comprising:
a mold, used for injecting a second metal in liquid form which is a metal different from a first metal layer onto a semi-finished cover disposed in the mold and formed of the first metal layer, so as to form a second metal layer on the first metal layer,
wherein the mold comprises a pressing component, for applying a pressure to the second metal layer located in the mold.

4. The device according to Claim 3, wherein the mold comprises an overflow port, so that a surplus of the second metal in liquid form overflows through the overflow port when the pressing component presses the second metal layer.

5. The device according to Claim 3, wherein the mold comprises a rear mold, and a reserved space provided between the rear mold and the pressing component, so that the second metal in liquid form is injected into the reserved space.

6. The device according to Claim 3, wherein the materials of the first metal layer and the second metal layer comprise stainless steel, zinc, aluminum, magnesium, chromium, titanium, copper, beryllium, nickel or an alloy thereof.

7. A method for manufacturing a cover comprising multiple metal layers, comprising:
injecting a first metal in liquid form into a space between a first front mold and a rear mold operating in cooperation with the first front mold, so as to form a first metal layer; and
injecting a second metal in liquid form onto the first metal layer in a semi-solid molten state in a second front mold in cooperation with the rear mold, so as to form a second metal layer on the first metal layer.

8. The method according to Claim 7, further comprising:
pressing the second metal layer with a pressure.

9. The method according to Claim 7, further comprising:
relatively moving the rear mold between the first front mold and the second front mold.

10. The method according to Claim 7, wherein the materials of the first metal layer and the second metal layer comprise stainless steel, zinc, aluminum, magnesium, chromium, titanium, copper, beryllium, nickel or an alloy thereof.

11. A device for manufacturing a cover comprising multiple metal layers, comprising:
a first front mold, operating in cooperation with a rear mold and used to inject a first metal in liquid form, so as to form a first metal layer; and
a second front mold, operating in cooperation with the rear mold and used to inject a second metal in liquid form onto the first metal layer in a semi-solid molten state, so as to form a second metal layer on the first metal layer.

12. The device according to Claim 11, wherein the second front mold further comprises a pressing component, for applying a pressure to the second metal layer.

13. The device according to Claim 12, wherein a reserved space is provided between the rear mold and the pressing component, so that the second metal in liquid form is injected into the reserved space, and the rear mold further comprises an overflow port, so that a surplus of the second metal in liquid form overflows through the overflow port when the pressing component presses the second metal layer.

14. The device according to Claim 11, further comprising: a movement component, for relatively moving the rear mold between the first front mold and the second front mold.

15. The device according to Claim 11, wherein the materials of the first metal layer and the second metal layer comprise stainless steel, zinc, aluminum, magnesium, chromium, titanium, copper, beryllium, nickel or an alloy thereof.
